# EUROPEAN PATENT SPECIFICATION

(11) **EP 4 214 749 B1**
(45) Date of publication and mention of the grant of the patent: **28.01.2026**
(21) Application number: 21778054.3
(22) Date of filing: 16.09.2021
(51) Int. Cl.: H01L 23/473, H01L 23/373, H01L 23/433

(54) **POWER MODULE AND METHOD FOR PRODUCING A POWER MODULE**
LEISTUNGSMODUL UND VERFAHREN ZUR HERSTELLUNG EINES LEISTUNGSMODULS
MODULE DE PUISSANCE ET PROCÉDÉ DE PRODUCTION DE MODULE DE PUISSANCE

(30) Priority: 17.09.2020 EP 20196695
(43) Date of publication of application: 26.07.2023
(73) Proprietor: Hitachi Energy Ltd, 8050 Zürich (CH)
(72) Inventor: PAVLICEK, Niko, 8041 Zürich (CH); COTTET, Didier, 8050 Zürich (CH); GRADINGER, Thomas, 5032 Aarau Rohr (CH); LIU, Chunlei, 5452 Oberrohrdorf (CH); MOHN, Fabian, 5408 Ennetbaden (CH); SALVATORE, Giovanni A., 34170 Gorizia (IT); SCHUDERER, Juergen, 8047 Zürich (CH); TORRESIN, Daniele, 5400 Baden (CH); TRAUB, Felix, 4059 Basel (CH)
(74) Representative: Epping - Hermann - Fischer
(86) International application number: PCT/EP2021/075486
(87) International publication number: WO 2022/058426

(56) References cited:
- EP-A1- 2 892 074
- WO-A1-2015/176992
- WO-A1-2019/219656
- DE-A1- 102009 045 063
- JP-A- 2001 320 185
- JP-A- 2016 001 766
- US-A1- 2012 313 252
- US-A1- 2013 264 702
- US-A1- 2016 260 648
- US-A1- 2017 263 527

## Description

### FIELD OF THE INVENTION

The invention relates to a power module and a method for producing a power module.

### BACKGROUND OF THE INVENTION

Power semiconductor modules used, for example, in inverters of electric cars, typically have to be cooled by a cooling unit using a liquid coolant. Thus, individual power semiconductor modules have to be integrated into the cooling unit for liquid cooling. This imposes the need for a reliable leak-tight seal between the power semiconductor modules and the cooling unit to prevent any risk of leakage into the power semiconductor modules.

State of the art is, for example, mounting the power semiconductor modules by screws with an O-ring sealing on the cooling unit. Alternatively, the power semiconductor modules can be mounted on a closed cooler. This requires a reliable bond between the power modules and the cooling unit with high thermal conductivity. However, this would require elevated process temperatures, which might cause damage and/or delamination of a casing of the power semiconductor modules.

Document DE 10 2011 0882 18 A1 describes an electronic power module, which is coupled with thermal coupling layers to a cooling element.

Document DE 10 2012 205590 A1 describes a power module for the use with an inverter and document WO 2015/176992 A1 describes a semiconductor power module having a heat interface, wherein the module is surrounded by a resin. Document US 2016/0260648 A1 describes a semi-conductor module with an encapsulating cement mass that covers a semi-conductor component, document US 2012/313252 A1 describes a semiconductor device and document WO 2019/219656 A1 describes a system for cooling a metal-ceramic substrate, a metal-ceramic substrate and a method for producing said system.

### DESCRIPTION OF THE INVENTION

It is an object of the invention to provide a power module which has an improved reliability and to provide a method for producing such a power module.

The object is achieved by the subject-matter of the independent claims. Further exemplary embodiments are evident from the dependent claims and the following description.

A first aspect of the invention relates to a power module. The term "power" here and in the following, for example, refers to power modules, power semiconductor modules and/or semiconductor chips adapted for processing voltages and currents of more than 100 V and/or more than 10 A, exemplary voltages up to 1200 V and currents of several hundred amperes. For example, the power module is used in automotive applications, such as electric vehicles, hybrid vehicles, motorbikes, buses, trucks, off-road construction vehicles and charging stations.

The power module has, for example, a main plane of extension. Lateral directions are aligned parallel to the main plane of extension and a vertical direction is aligned perpendicular to the main plane of extension.

According to the embodiment of the invention, the power module comprises at least one power semiconductor module having at least one semiconductor chip arranged on a substrate comprising at least one electrical insulating layer.

The semiconductor chip is based, for example, on silicon or a wide bandgap material, exemplarily silicon carbide. The semiconductor chip is, for example, formed as a diode and/or a switch. Such a switch is, for example, a transistor, a varistor, an insulated gate bipolar transistor, abbreviated as IGBT, or a metal oxide or insulator semiconductor field effect transistor, abbreviated as MOSFET.

The power semiconductor module, for example, comprises at least two semiconductor chips. The two semiconductor chips are arranged on the substrate, exemplarily the same substrate. For example, one of the semiconductor chips is formed as a switch and the other of the semiconductor chips is formed as a diode. In this case, the switch and the diode are connected antiparallel to one another. The two semiconductor chips being connected antiparallel to one another form, for example, a half bridge. For example, the power semiconductor module comprises one or more half bridges. In this case, the power semiconductor module comprises two or more semiconductor chips.

The substrate comprises, for example, an electrical insulating material. The electrical insulating material of the substrate comprises or consists of a ceramic such as AlO, AlN and/or SiN.

According to the embodiment, the power module comprises a lead frame arranged in electrical contact to the semiconductor chip. The lead frame comprises, for example, terminal parts, which are configured for external contacting of the power module. The lead frame comprises or consists, for example, of a metal, exemplarily Cu.

According to the embodiment, the power module comprises a base plate comprising cooling structures. The power semiconductor module is arranged on the base plate. The base plate is configured, for example, to cool the power semiconductor module during operation.

According to the embodiment, the power module comprises a bond layer connecting the power semiconductor module and the base plate. The bond layer comprises or consists, for example, of a metallic material. Thus, heat produced by the power semiconductor module during operation can be dissipated particularly well in the direction of the cooling structures. The bond layer is configured, for example, to attach the power semiconductor module to the base plate, exemplarily in a mechanically stable manner.

According to the embodiment, the power module comprises a mold compound arranged on the power semiconductor module, the bond layer and the base plate. For example, the mold compound is in direct contact to the power semiconductor module, the bond layer and the base plate. The mold compound comprises or consists of an epoxy mold compound, exemplarily an epoxy resin. Advantageously, a strength of the attachment of the power semiconductor module to the base plate is thus further increased.

According to the embodiment of the power module, the bond layer is encapsulated completely by the power semiconductor module, the base plate and the mold compound. For example, the power semiconductor module covers at least a part of an outer surface of the bond layer facing the power semiconductor module. Further, the base plate covers at least a part of the outer surface of the bond layer facing the base plate. For example, the mold compound covers a rest of the outer surface of the bond layer, which is not covered by the power semiconductor module and the base plate. Therefore, the bond layer is exemplarily three-dimensionally encapsulated. Exemplarily, the bond layer does not comprise an outer surface not being covered by the power semiconductor module, the base plate and the mold compound. Having such a mold compound, aging effects of the bond layer can be reduced advantageously.

According to the embodiment of the power module, the lead frame is arranged at least partially within the mold compound. For example, the terminal parts of the lead frame protrude from the mold compound in order to be externally contactable.

According to the embodiment of the power module, the base plate comprises micro channels connected to at least one inlet port and at least one outlet port. For example, the micro channels are embedded in the base plate. "Embedded" means here, that an outer surface of the micro channels are completely enclosed by the material of the base plate. The micro channels are formed, for example, from rods. For example, a liquid coolant can flow from the inlet port through the micro channels to the outlet port. Exemplary, the liquid coolant is pumped from the inlet port via the micro channels to the outlet port.

In summary, such a power module can provide, inter alia, the following advantages. Overall dimensions of the power module can be reduced because additional overhead for mounting of the power semiconductor module to the base plate is omitted. Furthermore, the risk of coolant leakage into the power semiconductor module is mitigated, since within such a power module, a metallurgical sealed cooler as the cooling structure can be used. Moreover, such a power module has advantageously a comparably high cycling capability, since the bond layer is encapsulated in the mold compound. Such a constrained bond layer results in a reduced von Mises strain. Thus, a maximum operation temperature of the semiconductor chips can be set exemplarily high, leading to savings of semiconductor area Advantageously, heat generated during operation of the power module can be dissipated away from the power semiconductor module via the base plate comprising such micro channels particularly effectively.

According to at least one embodiment of the power module, the bond layer is a solder layer or a sinter layer.

According to at least one embodiment of the power module, the mold compound is arranged at least in places in direct contact with a side surface of the base plate. The mold compound, for example, protrudes beyond the outer surface of the bond layer in vertical direction, in direction to the base plate. This is to say that the mold compound and the base plate overlap in a side view. Advantageously, the bond layer is thus further protected from external contamination. According to at least one embodiment of the power module, the substrate further comprises a first metallization layer and a second metallization layer, and the electrical insulating layer is arranged between the first metallization layer and the second metallization layer.

For example, the semiconductor chip is arranged on the first metallization layer. Further, the first metallization layer, for example is structured. In this case, the first metallization layer covers the electrical insulating layer only in regions. The first metallization layer is, for example, structured to provide electrical conductors to which the semiconductor chip is connected.

According to at least one embodiment of the power module, the base plate has a protruding part protruding beyond the bond layer in lateral directions.

According to at least one embodiment of the power module, the mold compound is arranged on an outer surface of the protruding part in direct contact. For example, the mold compound is arranged on a side surface of the protruding part extending in vertical direction. Furthermore, the mold compound is, for example, arranged on a top surface of the protruding part extending in lateral directions, facing the power semiconductor module. According to this embodiment, the outer surface of the protruding part, on which the mold compound is arranged, is formed from the side surface of the protruding part and the top surface of the protruding part.

According to at least one embodiment of the power module, the cooling structures comprise pin fins. For example, the pin fins are arranged on a bottom surface of the base plate, facing away from the power semiconductor module. Each pin fin is exemplarily formed from a pillar extending in vertical direction. For example, all of the pin fins have a common direction of extension being parallel to the vertical direction. The pin fins are formed, for example, from the same material as the base plate, such as Cu. For example, the pin fins increase an area of the bottom surface of the base plate. Advantageously, heat dissipation can be improved because of such pin fins.

According to at least one embodiment of the power module, the base plate comprises interlocking features configured to fix the mold compound to the base plate. For example, an outer surface of the base plate being in direct contact to the mold compound comprises the interlocking features. The interlocking features are formed, for example, from the same material as the base plate. The interlocking features have the form, for example, of dimples, indents and/or grooves. The interlocking features advantageously increase an adhesive force between the mold compound and the base plate. According to at least one embodiment, the power module comprises at least two power semiconductor modules being arranged spaced apart from one another. For example, the base plate is a common base plate for the power semiconductor modules. Advantageously, due to such a common base plate, a flow of the liquid coolant is particular good since there are no weld seams or sealing parts between the power semiconductor modules within the base plate.

According to at least one embodiment of the power module, the mold compound is arranged on the two power semiconductor modules.

According to at least one embodiment, the mold compound comprises a recess between the two power semiconductor modules. For example, the recess does not overlap with the power semiconductor modules in top view.

According to at least one embodiment of the power module, the recess does not penetrate the mold compound completely. For example, a height in vertical direction of the mold compound between the two power semiconductor modules is smaller than a height in vertical direction of the mold compound over the two semiconductor modules. The mold compound, for example, is simply connected. This is to say that the mold compound extends continuously over the semiconductor modules.

Advantageously, due to the recess the risk of a delamination of the mold compound due to a mismatch of coefficients of thermal expansion between the mold compound and the semiconductor power module components and the base plate is decreased in comparison to a mold compound without a recess. Further, a warpage of the power module is thus also reduced.

According to at least one embodiment of the power module, the recess penetrates the mold compound completely. For example, the recess exposes the base plate between the two power semiconductor modules. For example, the mold compound is multiple connected. This is to say that the mold compound according to this embodiment is formed discontinuously.

A second aspect of the invention relates to a method for producing a power module. Preferably the method produces a power module described herein above. All features disclosed in connection with the power module are therefore also disclosed in connection with the method and vice versa. According to at least one embodiment, the method comprises the step of providing at least one power semiconductor module, wherein at least one semiconductor chip is bonded on a substrate comprising at least one electrical insulating layer. Bonding refers here and in the following to soldering, sintering and/or welding, for example.

According to at least one embodiment, the method comprises the step of applying a lead frame in electrical contact to the semiconductor chip.

According to at least one embodiment the method comprises the step of providing a base plate comprising cooling structures, wherein the base plate comprises micro channels connected to at least one inlet port and at least one outlet port.

According to at least one embodiment, the method comprises the step of bonding the power semiconductor module to the base plate with a bond layer. For the case that the power module comprises more than one power semiconductor module, all the power semiconductor modules, for example, are bonded in a single process step to the base plate.

According to at least one embodiment, the method comprises the step of applying a mold compound on the power semiconductor module, the bond layer and the base plate, such that the bond layer is encapsulated completely by the power semiconductor module, the base plate and the mold compound, and the lead frame is arranged at least partially within the mold compound. The mold compound is applied, for example, via a transfer molding process or compression molding process. Using the transfer molding process, mold compound volumes up to 120 cm³ can be achieved.

Exemplary, the step of applying the mold compound is performed after the method step of bonding the power semiconductor module to the base plate with the bond layer.

Using such a method has the following advantages. In comparison to power modules according to the state of the art, the total number of method steps are reduced, since mounting of individual power semiconductor modules on the base plate is omitted. Further, an alignment accuracy between individual power semiconductor modules is particularly accurate.

According to at least one embodiment of the method, the semiconductor chip is bonded to the substrate by soldering or sintering.

According to at least one embodiment of the method, the substrate is a lead frame being applied from a single-piece lead frame with dam-bar structures. For example, the lead frame having the dam-bar structures can comprise bars being in electrical contact to the semiconductor chip. The bars are configured to provide an electrical contact to the semiconductor chip. Further, the lead frame having the dam-bar structures can comprise dams, wherein the dams are arranged between two bars and wherein the dams extend perpendicular to these bars in lateral directions. Exemplary, the dams surround semiconductor chip and the substrate completely in lateral directions. These dams can be used as a delimiting element for the mold compound for the transfer molding process.

According to at least one embodiment of the method, the base plate is pressed in the direction of the power semiconductor module during the application of the mold compound. Exemplary, the base plate is pressed in vertical direction in the direction of the power semiconductor module during the application of the mold compound. Advantageously, such an encapsulated bond layer is particularly well protected from external contaminations.

### BRIEF DESCRIPTION OF THE DRAWINGS

The subject-matter of the invention will be explained in more detail in the following with reference to exemplary embodiments which are illustrated in the attached drawings.
Figures 1 and 2 each schematically show a top view on a power module according to an exemplary embodiment of the invention.
Figures 3 and 4 each schematically show a cross-section through a power module according to an exemplary embodiment of the invention.
Figure 5 shows an exemplary representation of a thermomechanical strain simulation of different power modules.
Figures 6, 7 and 8 each schematically show a cross-section through a power module used for the simulation.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

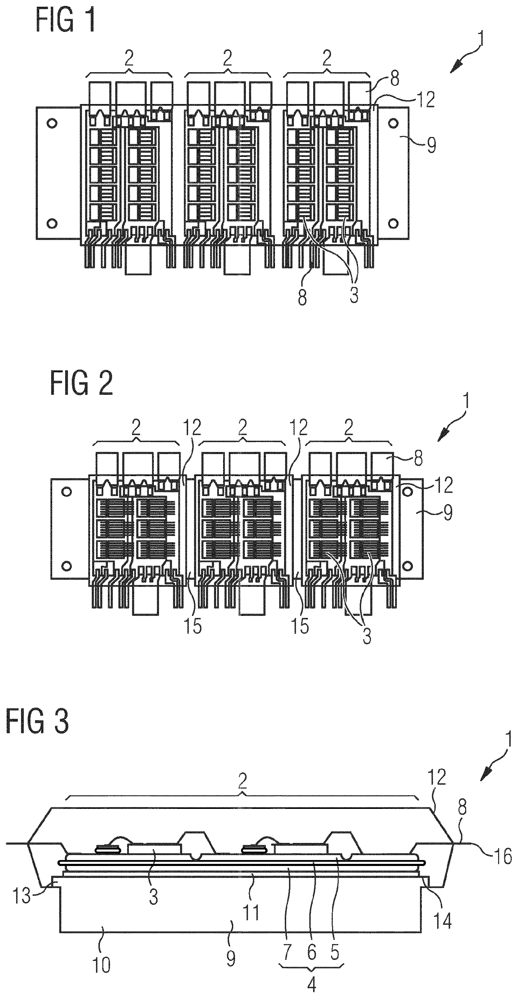

The power module 1 according to the exemplary embodiment of Figure 1 comprises three power semiconductor modules 2, each having twenty semiconductor chips 3, wherein ten of the semiconductor chips 3 are formed of switches and ten of the semiconductor chips 3 are formed of diodes. Further, the power module 1 comprises a lead frame 8 arranged in electrical contact to the semiconductor chips 3.

The power module 1 further comprises a base plate 9, on which the semiconductor modules 2 are arranged on. The semiconductor modules 2 are attached to the base plate 9 with a bond layer 11, being described in more detail in connection with the exemplary embodiment of Figure 3.

A mold compound 12 is arranged on the power semiconductor modules 2. The mold compound 12 is arranged continuously over all the semiconductor modules 2. This is to say that the mold compound 12 is simply connected.

Each power semiconductor module 2 shown in Figure 2 comprise in contrast to Figure 1 six semiconductor chips 3. In addition, in contrast to Figure 1, the mold compound 12 comprises a recess 15 between neighboring power semiconductor modules 2. Each recess 15 penetrates the mold compound 12 completely, such that a base plate 9 between neighbouring power semiconductor modules 2 is exposed. In this exemplary embodiment, the mold compound 12 is thus multiple connected.

The power module 1 according to the exemplary embodiment of Figure 3 corresponds to a cross-section of a power module 1 according to Figure 1 or 2. The semiconductor chips 3 of a power semiconductor module 2 are arranged on a substrate 4.The substrate 4 comprises a first metallization layer 5, an electrical insulating layer 6 and a second metallization layer 7. The electrical insulating layer 6 is arranged between the first metallization 5 layer and the second metallization layer 7.

The first metallization layer 5 is structured in regions, wherein the regions are electrically insulated from one another. Each semiconductor chip 3 is arranged on one of the regions. The regions of the first metallization layer 5 are interconnected according to this exemplary embodiment with bonding wires.

The power module 1 further comprises a lead frame 8. The lead frame 8 is configured to provide an electrical contact to the semiconductor chips 3 and is thus in electrical contact to the semiconductor chips 3. In this exemplary embodiment, the lead frame 8 is contacted to the first metallization layer 5. Exemplary, the lead frame 8 is in direct contact to a region of the first metallization layer 5. Further, the lead frame 8 comprises terminal parts 16, which are configured for external contacting of the power module 1.

The power semiconductor module 2 is arranged on a base plate 9 with a bond layer 11. The base plate 9 comprises cooling structures 10 in order to dissipate heat away from the power semiconductor module 2. Furthermore, due to the bond layer 11 the power semiconductor module 2 is attached to the base plate 9, exemplary, in a mechanical stable manner.

The base plate 9 is a plate having a protruding part 13 protruding beyond the bond layer 11 in lateral directions. The protruding part 13 comprises a top surface extending in lateral directions, facing the power semiconductor module 2. Further, the protruding part 13 comprises a side surface, connected to the top surface, extending in vertical direction. This is to say that an outer surface of the protruding part 13 is formed from the side surface of the protruding part 13 and the top surface of the protruding part 13. In addition, the top surface of the protruding part 13 and a top surface of the base plate 9, facing the power semiconductor module 2, are arranged in a common plane.

In addition a mold compound 12 is arranged on the power semiconductor module 2, the bond layer 11 and the base plate 9. The mold compound 12 is in direct contact to the power semiconductor module 2. Exemplary, all components of the power semiconductor module 2 are embedded in the mold compound 12. Further the bond layer 11 and the base plate 9 are also in direct contact to the mold compound 12.

Exemplary, the mold compound 12 is arranged on the outer surface of the protruding part 13, i.e. the side surface of the protruding part 13 and the top surface of the protruding part 13, in direct contact. Furthermore, the lead frame 8 is arranged at least partially within the mold compound 12. The terminal parts 16 of the lead frame 8 protrude from the mold compound 12 in order to be externally contactable.

It is further possible that the outer surface of the base plate 6 being in direct contact to the mold compound 12 comprises the interlocking features 14, i.e. dimples, indents and/or grooves.

Having such a mold compound 12, the bond layer 11 is completely encapsulated by the power semiconductor module 2, the base plate 6 and the mold compound 12. This is to say that the bond layer 11 is three-dimensionally encapsulated. The bond layer 11 has no outer surface being freely accessible.

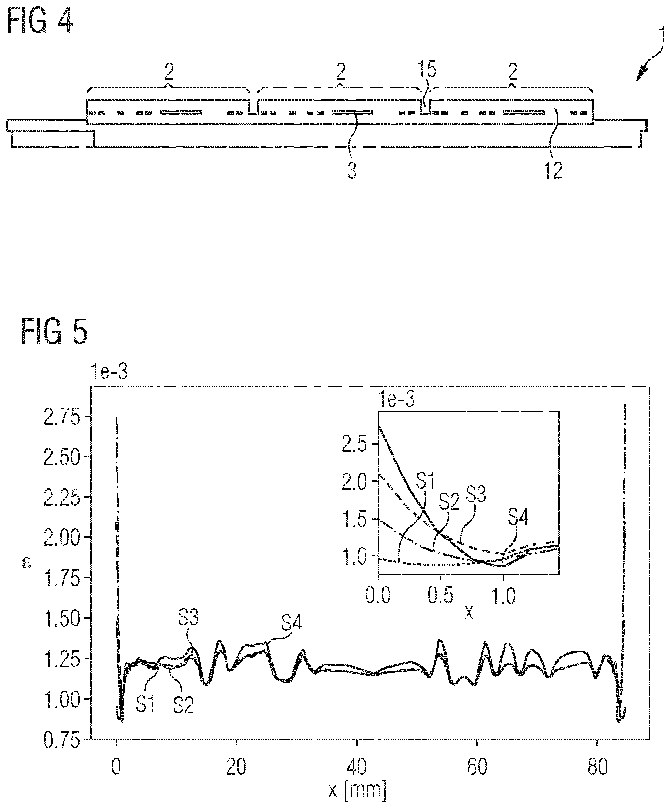

The mold compound 12 according to the exemplary embodiment of Figure 4 comprises recesses 15, which do not penetrate the mold compound 12 completely. A height in vertical direction of the mold compound 12 between the direct neighbouring power semiconductor modules 2 is smaller than a height in vertical direction of the mold compound 12 over direct neighbouring semiconductor modules 2.

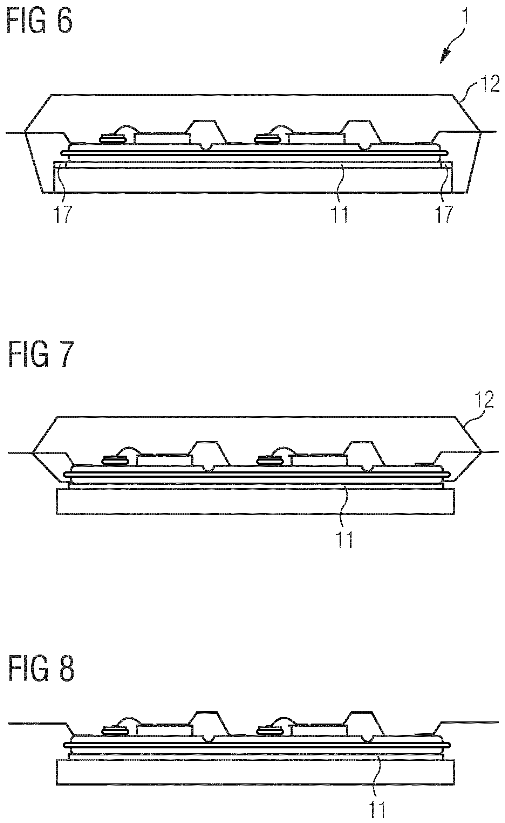

A thermomechanical strain behaviour of different power modules is plotted according to the diagram in Figure 5. A structure of the different power modules is shown in connection with Figures 3, 6, 7 and 8. The power module according to Figure 3 is marked with a reference sign S1, the power module according to Figure 6 is marked with a reference sign S2, the power module according to Figure 7 is marked with a reference sign S3 and the power module according to Figure 8 is marked with a reference sign S4.

In the diagram, strain values ε in arbitrary units of the respective power module S1, S2, S3 and S4 are provided on the y-axis. Here, the strain values ε correspond to an elastic strain in the respective bond layer 11 due to a temperature increase of 5 Kelvin. On the x-axis, a position x in mm of the respective power module S1, S2, S3 and S4 is provided.

The curves of S1, S2, S3 and S4 differ distinctively at an edges of the bond layer 11, since bond layers 11 typically degrade by delaminating from the edges due to thermal cycles. The strain values ε of the edges of the bond layers 11 of power modules S1, S2, S3 and S4 are also shown in the inset of the diagram. Because strain is proportional to stress, and eventually correlates to lifetime, the curves S1, S2, S3 and S4 can be used to make a qualitative lifetime assessment.

The strain values ε at the edge is lowest for the power module S1, since the bond layer 11 is fully encapsulated in mold compound 12. That is to say that the mold compound 12 compresses the bond layer 11 both in vertical direction and in lateral directions. In contrast, the corresponding strain value ε is highest for the power module S4, having no mold compound 12.

A bond layer 11 of the power module S3 according to Figure 7 is not completely encapsulated. Since here a power semiconductor module 2 is first overmolded, and only subsequently bonded to a base plate 9, the bond layer 11 is exposed and not constrained. For the power module S3, the strain value ε is smaller compared to the power module S4. Further, the strain value ε of power module S3 is approximately twice as high as in the power module S1 because the mold compound 12 only stiffens the assembly in vertical direction, but the bond layer 11 is free of the mold compound 12 in lateral directions.

The power module S2 corresponds basically to the power module S1. For simulation reasons, the bond layer 11 of power module S2 comprises at its end regions a virtual soft element 17. This virtual soft element 17 surrounds the bond layer 11 in lateral directions. Hence, the bond layer 11 is compressed in vertical direction by the mold compound 12 but elongation in lateral directions is virtually unconstrained. This results in strain values ε between the power module S1 and power module S3.

Advantageously, such a simulation shows that encapsulating a bond layer 11 by a mold compound 12 will significantly enhance its lifetime. Hence, the power module S1 will result in higher thermal cycling capability compared to power modules S3 or S4.

### LIST OF REFERENCE SYMBOLS

1 power module
2 power semiconductor module
3 semiconductor chip
4 substrate
5 first metallization
6 electrical insulating layer
7 second metallization
8 lead frame
9 base plate
10 cooling structures
11 bond layer
12 mold compound
13 protruding part
14 interlocking features
15 recess
16 terminal part
17 virtual soft element
ε strain value
x position

## Claims

1. A power module (1) comprising
- at least one power semiconductor module (2) having at least one semiconductor chip (3) arranged on a substrate (4) comprising at least one electrical insulating layer,
- a lead frame (8) arranged in electrical contact to the at least one semiconductor chip (3),
- a base plate (9) comprising cooling structures (10),
- a bond layer (11) connecting the power semiconductor module (2) and the base plate (9), and
- a mold compound (12) arranged on the power semiconductor module (2), the bond layer (11) and the base plate (9), wherein
- the bond layer (11) is encapsulated completely by the power semiconductor module (2), the base plate (9) and the mold compound (12),
- the lead frame (8) is arranged at least partially within the mold compound (12), and
- the base plate (9) comprises micro channels connected to at least one inlet port and at least one outlet port.

2. The power module (1) according to claim 1, wherein the bond layer (11) is a solder layer or a sinter layer.

3. The power module (1) according to any of the preceding claims, wherein the mold compound (12) is arranged at least in places in direct contact on a side surface of the base plate (9).

4. The power module (1) according to any of the preceding claims, wherein
- the substrate (4) further comprises a first metallization layer (5) and a second metallization layer (7), and
- the electrical insulating layer (6) is arranged between the first metallization (5) layer and the second metallization layer (7).

5. The power module (1) according to any of the preceding claims, wherein
- the base plate (9) has a protruding part (13) protruding beyond the bond layer (11) in lateral directions, and
- the mold compound (12) is arranged on an outer surface of the protruding part (13) in direct contact.

6. The power module (1) according to any of the preceding claims, wherein
- the cooling structures (10) comprises pin fins.

7. The power module (1) according to any of the preceding claims, wherein the base plate (9) comprises interlocking features (14) configured to fix the mold compound (12) to the base plate (9).

8. The power module (1) according to any of the preceding claims comprising
- at least two power semiconductor modules (2) being arranged spaced apart from one another, wherein
- the mold compound (12) is arranged on the two power semiconductor modules (2).

9. The power module (1) according to claim 8, wherein the mold compound (12) comprises a recess (15) between the two power semiconductor modules (2).

10. The power module (1) according to claim 8 or 9, wherein the recess (15) does not penetrate the mold compound (12) completely.

11. The power module (1) according to claim 8 or 9, wherein the recess (15) penetrates the mold compound (12) completely.

12. A method for producing a power module (1) comprising the steps of:
- providing at least one power semiconductor module (2), wherein at least one semiconductor chip (3) is bonded on a substrate (4) comprising at least one electrical insulating layer,
- applying a lead frame (8) in electrical contact to the at least one semiconductor chip (3),
- providing a base plate (9) comprising cooling structures (10), wherein the base plate (9) comprises micro channels connected to at least one inlet port and at least one outlet port,
- bonding the power semiconductor module (2) to the base plate (9) with a bond layer (11),
- applying a mold compound (12) on the power semiconductor module (2), the bond layer (11) and the base plate (9), such that the bond layer (11) is encapsulated completely by the power semiconductor module (2), the base plate (9) and the mold compound (12), and the lead frame (8) is arranged at least partially within the mold compound (12).

13. The method according to claim 12, wherein the at least one semiconductor chip (3) is bonded to substrate (4) by soldering or sintering.

14. The method according to claim 12 or 13, wherein the substrate (4) is a lead frame (8) being applied from a single-piece lead frame (8) with dam-bar structures.

15. The method according to any of claims 12 to 14, wherein the base plate (9) is pressed in direction of the power semiconductor module (2) during the application of the mold compound (12).

## Patentansprüche

1. Leistungsmodul (1), das Folgendes umfasst:
- mindestens ein Leistungshalbleitermodul (2) mit mindestens einem Halbleiterchip (3), der auf einem Substrat (4) angeordnet ist, das mindestens eine elektrisch isolierende Schicht umfasst,
- einen Leiterrahmen (8), der in elektrischem Kontakt mit dem mindestens einen Halbleiterchip (3) angeordnet ist,
- eine Grundplatte (9), die Kühlstrukturen (10) umfasst,
- eine Verbindungsschicht (11), die das Leistungshalbleitermodul (2) und die Grundplatte (9) verbindet, und
- eine Formmasse (12), die auf dem Leistungshalbleitermodul (2), der Verbindungsschicht (11) und der Grundplatte (9) angeordnet ist, wobei
- die Verbindungsschicht (11) durch das Leistungshalbleitermodul (2), die Grundplatte (9) und die Formmasse (12) vollständig verkapselt ist,
- der Leiterrahmen (8) zumindest teilweise in der Formmasse (12) angeordnet ist, und
- die Grundplatte (9) Mikrokanäle umfasst, die mit mindestens einer Einlassöffnung und mindestens einer Auslassöffnung verbunden sind.

2. Leistungsmodul (1) nach Anspruch 1, wobei die Verbindungsschicht (11) eine Lötmittelschicht oder eine Sinterschicht ist.

3. Leistungsmodul (1) nach einem der vorhergehenden Ansprüche, wobei die Formmasse (12) zumindest an Stellen in direktem Kontakt auf einer Seitenfläche der Grundplatte (9) angeordnet ist.

4. Leistungsmodul (1) nach einem der vorhergehenden Ansprüche, wobei
- das Substrat (4) ferner eine erste Metallisierungsschicht (5) und eine zweite Metallisierungsschicht (7) umfasst, und
- die elektrisch isolierende Schicht (6) zwischen der ersten Metallisierungsschicht (5) und der zweiten Metallisierungsschicht (7) angeordnet ist.

5. Leistungsmodul (1) nach einem der vorhergehenden Ansprüche, wobei
- die Grundplatte (9) einen vorstehenden Abschnitt (13) aufweist, der in seitlichen Richtungen über die Verbindungsschicht (11) hinaus vorsteht, und
- die Formmasse (12) auf einer Außenfläche des vorstehenden Abschnitts (13) in direktem Kontakt angeordnet ist.

6. Leistungsmodul (1) nach einem der vorhergehenden Ansprüche, wobei
- die Kühlstrukturen (10) Pin-Fin-Kühlkörper umfassen.

7. Leistungsmodul (1) nach einem der vorhergehenden Ansprüche, wobei die Grundplatte (9) Kopplungsmerkmale (14) umfasst, die konfiguriert sind, die Formmasse (12) an der Grundplatte (9) zu befestigen.

8. Leistungsmodul (1) nach einem der vorhergehenden Ansprüche, das Folgendes umfasst:
- mindestens zwei Leistungshalbleitermodule (2), die voneinander beabstandet angeordnet sind, wobei
- die Formmasse (12) auf den zwei Leistungshalbleitermodulen (2) angeordnet ist.

9. Leistungsmodul (1) nach Anspruch 8, wobei die Formmasse (12) eine Aussparung (15) zwischen den zwei Leistungshalbleitermodulen (2) umfasst.

10. Leistungsmodul (1) nach Anspruch 8 oder 9, wobei die Aussparung (15) die Formmasse (12) nicht vollständig durchdringt.

11. Leistungsmodul (1) nach Anspruch 8 oder 9, wobei die Aussparung (15) die Formmasse (12) vollständig durchdringt.

12. Verfahren zum Herstellen eines Leistungsmoduls (1), das die folgenden Schritte umfasst:
- Bereitstellen mindestens eines Leistungshalbleitermoduls (2), wobei mindestens ein Halbleiterchip (3) auf ein Substrat (4) gebondet wird, das mindestens eine elektrisch isolierende Schicht umfasst,
- Anbringen eines Leiterrahmens (8) in elektrischem Kontakt an dem mindestens einen Halbleiterchip (3),
- Bereitstellen einer Grundplatte (9), die Kühlstrukturen (10) umfasst, wobei die Grundplatte (9) Mikrokanäle umfasst, die mit mindestens einer Einlassöffnung und mindestens einer Auslassöffnung verbunden sind,
- Verbinden des Leistungshalbleitermoduls (2) mit einer Verbindungsschicht (11) mit der Grundplatte (9),
- Aufbringen einer Formmasse (12) auf das Leistungshalbleitermodul (2), die Verbindungsschicht (11) und die Grundplatte (9), derart, dass die Verbindungsschicht (11) durch das Leistungshalbeitermodul (2), die Grundplatte (9) und die Formmasse (12) vollständig verkapselt wird und der Leiterrahmen (8) zumindest teilweise in der Formmasse (12) angeordnet wird.

13. Verfahren nach Anspruch 12, wobei der mindestens eine Halbleiterchip (3) durch Löten oder Sintern mit dem Substrat (4) verbunden wird.

14. Verfahren nach Anspruch 12 oder 13, wobei das Substrat (4) ein Leiterrahmen (8) ist, der von einem einteiligen Leiterrahmen (8) mit Sperrstrebenstrukturen bereitgestellt wird.

15. Verfahren nach einem der Ansprüche 12 bis 14, wobei die Grundplatte (9) während des Aufbringens der Formmasse (12) in Richtung des Leistungshalbleitermoduls (2) gedrückt wird.

## Revendications

1. Module (1) de puissance comprenant
- au moins un module semi-conducteur (2) de puissance comportant au moins une puce semi-conductrice (3) disposée sur un substrat (4) comportant au moins une couche électriquement isolante,
- une grille (8) de connexion disposée en contact électrique avec la ou les puces semi-conductrices (3),
- une plaque (9) de base comportant des structures (10) de refroidissement,
- une couche (11) de liaison reliant le module semi-conducteur (2) de puissance et la plaque (9) de base, et
- un composé (12) de moulage disposé sur le module semi-conducteur (2) de puissance, la couche (11) de liaison et la plaque (9) de base, dans lequel
- la couche (11) de liaison est complètement encapsulée par le module semi-conducteur (2) de puissance, la plaque (9) de base et le composé (12) de moulage,
- la grille (8) de connexion est disposée au moins partiellement à l'intérieur du composé (12) de moulage, et
- la plaque (9) de base comprend des micro-canaux reliés à au moins un orifice d'entrée et au moins un orifice de sortie.

2. Module (1) de puissance selon la revendication 1, la couche (11) de liaison étant une couche de soudure ou une couche frittée.

3. Module (1) de puissance selon l'une quelconque des revendications précédentes, le composé (12) de moulage étant agencé au moins à des endroits en contact direct sur une surface latérale de la plaque (9) de base.

4. Module (1) de puissance selon l'une quelconque des revendications précédentes, dans lequel
- le substrat (4) comprend en outre une première couche (5) de métallisation et une seconde couche (7) de métallisation, et
- la couche isolante électrique (6) est disposée entre la première couche (5) de métallisation et la seconde couche (7) de métallisation.

5. Module (1) de puissance selon l'une quelconque des revendications précédentes, dans lequel
- la plaque (9) de base présente une partie saillante (13) dépassant au-delà de la couche (11) de liaison dans des directions latérales, et
- le composé (12) de moulage est disposé sur une surface extérieure de la partie saillante (13) en contact direct.

6. Module (1) de puissance selon l'une quelconque des revendications précédentes, dans lequel
- les structures (10) de refroidissement comprennent des ailettes à broches.

7. Module (1) de puissance selon l'une quelconque des revendications précédentes, la plaque (9) de base comprenant des éléments (14) de verrouillage réciproque configurés pour fixer le composé (12) de moulage à la plaque (9) de base.

8. Module (1) de puissance selon l'une quelconque des revendications précédentes, comprenant
- au moins deux modules semi-conducteurs (2) de puissance disposés de façon à être espacés l'un par rapport à l'autre, dans lequel
- le composé (12) de moulage est disposé sur les deux modules semi-conducteurs (2) de puissance.

9. Module (1) de puissance selon la revendication 8, le composé (12) de moulage comprenant un évidement (15) entre les deux modules semi-conducteurs (2) de puissance.

10. Module (1) de puissance selon la revendication 8 ou 9, l'évidement (15) ne pénétrant pas complètement dans le composé (12) de moulage.

11. Module (1) de puissance selon la revendication 8 ou 9, l'évidement (15) pénétrant complètement dans le composé (12) de moulage.

12. Procédé de production d'un module (1) de puissance comprenant les étapes de :
- mise en place d'au moins un module semi-conducteur (2) de puissance, au moins une puce semi-conductrice (3) étant collée sur un substrat (4) comprenant au moins une couche isolante électrique,
- application d'une grille (8) de connexion en contact électrique avec la ou les puces semi-conductrices (3),
- mise en place d'une plaque (9) de base comprenant des structures (10) de refroidissement, la plaque (9) de base comprenant des microcanaux reliés à au moins un orifice d'entrée et au moins un orifice de sortie,
- la liaison du module semi-conducteur (2) de puissance avec la plaque (9) de base à l'aide d'une couche (11) de liaison,
- application d'un composé (12) de moulage sur le module semi-conducteur (2) de puissance, la couche (11) de liaison et la plaque (9) de base, de telle sorte que la couche (11) de liaison soit complètement encapsulée par le module semi-conducteur (2) de puissance, la plaque (9) de base et le composé (12) de moulage, et que la grille (8) de connexion soit disposée au moins partiellement à l'intérieur du composé (12) de moulage.

13. Procédé selon la revendication 12, la ou les puces semi-conductrices (3) étant liées au substrat (4) par brasage ou frittage.

14. Procédé selon la revendication 12 ou 13, le substrat (4) étant une grille (8) de connexion appliquée à partir d'une grille (8) de connexion monobloc avec des structures digue-barre.

15. Procédé selon l'une quelconque des revendications 12 à 14, la plaque (9) de base étant pressée en direction du module semi-conducteur (2) de puissance pendant l'application du composé (12) de moulage.
